## Europäisches Patentamt

## European Patent Office

## Office européen des brevets

(11) Publication number: **0 211 517 B1**

# EUROPEAN PATENT SPECIFICATION

(45) Date of publication of the patent specification: 05.09.90

(51) Int. Cl.⁵: **H05K 9/00**

(21) Application number: 86305104.1

(22) Date of filing: 01.07.86

(54) High voltage transient protection device.

(30) Priority: 02.08.85 US 761799

(43) Date of publication of application:
25.02.87 Bulletin 87/9

(45) Publication of the grant of the patent:
05.09.90 Bulletin 90/36

(84) Designated Contracting States:
DE FR

(56) References cited:
AU-A- 532 286
DE-A- 2 229 301
DE-A- 2 443 304
GB-A- 2 053 579
US-A- 3 676 742
US-A- 4 158 254

(73) Proprietor: GENERAL MOTORS CORPORATION,
General Motors Building 3044 West Grand Boulevard,
Detroit Michigan 48202(US)

(72) Inventor: Lippmann, Raymond, 2426 Whitmore Lake Rd,
Ann Arbor, MI 48103(US)
Inventor: Chintyan, James Robert, 2220 Old Hickory
Blvd., Davison, MI 48423(US)

(74) Representative: Denton, Michael John et al, Patent
Section Vauxhall Motors Limited 1st Floor Gideon
House 26 Chapel Street, Luton Bedfordshire
LU1 2SE(GB)

## Description

This invention relates to a high voltage transient protection device and particularly to such a device on a printed circuit board according to the first part of claim 1 and as known e.g. from US-A 3 676 742.

High voltage transients such as those caused by electrostatic discharge can have adverse effects on electrical circuitry. For example, the high voltage transients may break down dielectrics causing arcing between various portions of circuits. Passive components can fail in a variety of ways. The arcing may locally destroy dielectrics within capacitors causing them to develop low series resistance or they may vaporize or fuse materials used to fabricate resistors. The energies, currents and voltages associated with electrostatic discharges may cause semiconductors to fail. Sufficient energies are present to melt bonding wires and local areas of thin semiconductor material. The high voltage transients may cause semiconductors to fail or to behave abnormally.

The detrimental effects of high voltage transients are accentuated as circuit densities are increased and as parts are miniaturized. Then distances between the conductors decrease so that as electrical field intensity increases the ability of materials to behave as insulators is reduced. Moreover the energy dissipated by an electrostatic discharge is absorbed by a smaller device thereby creating a greater temperature rise than in the case of a large device. While earlier concerns were to limit high voltage transients to several thousand volts it is now important to limit high voltage transients to relatively low values, say, a few hundred volts.

To overcome these difficulties it is known to protect semiconductors and other components and circuits by limiting currents with resistors while providing alternative discharge mechanisms and paths. Specifically, it has been proposed (as in US Patent No.3,676,742) to incorporate a spark gap between adjacent conductive paths on a printed circuit board to discharge high voltages at the input terminals of the printed circuit boards to avoid the destructive dissipation of energy at sensitive portions of the circuit. These arrangements, however, have the disadvantage that the high voltage transients are not controlled to a low level and that the discharge voltage is not consistent over a period of time and stable in adverse operating environments. They also have the disadvantage that any current limiting resistor is not protected so that it does not become bypassed or damaged. Further, they have the disadvantage that the high voltage transient protection device may be destroyed or debilitated by a high voltage transient rather than remain operative to maintain circuit protection even after repeated applications of high voltage transients. It is also known to cover spark gaps with a dielectric coating, however, this presents two problems; first the breakdown potential of the spark gap is greatly increased as compared to the breakdown potential in air and moreover it can be expected that the dielectric coating would be destroyed at least in part by a single discharge so that its effectiveness would be reduced or lost.

It is, therefore, an object of the present invention to overcome the above disadvantages to provide a high voltage transient protection device effective to discharge high voltage transients at relatively low voltages and which is consistent in operation over time and under a variety of ambient conditions. It is a further object of the invention to provide such a high voltage transient protection device on a printed circuit board covered with a conformal coating.

To this end, a high voltage transient protection device in accordance with the present invention is characterised by the features specified in the characterising portion of Claim 1.

The invention is carried out by providing on a printed circuit board having a substrate of dielectric material at least a pair of conductors closely spaced to define a spark gap for discharging high voltages, and a tape on the printed circuit board overlying the spark gap and trapping gas at the spark gap. The invention is further carried out by providing a spark gap as described with a current limiting resistor in at least one of the conductors and a conformal coating covering the printed circuit board including the tape and the current limiting resistor.

This invention is further described, by way of example, with reference to the following description taken in conjunction with the accompanying drawings wherein like reference numerals refer to like parts and wherein:-

Figure 1 is a diagrammatic top view of a printed circuit board incorporating a high voltage transient protection device according to the invention with conformal coating removed for clarity;

Figure 2 is an isometric view of a portion of the printed circuit board of Figure 1 illustrating the high voltage transient protection device according to the invention;

Figure 3 is a cross sectional view of the printed circuit board taken along lines 3-3 of Figure 2 but including a conformal coating; and

Figure 4 is a top view of a printed circuit board incorporating an array of high voltage transient protection devices according to the invention.

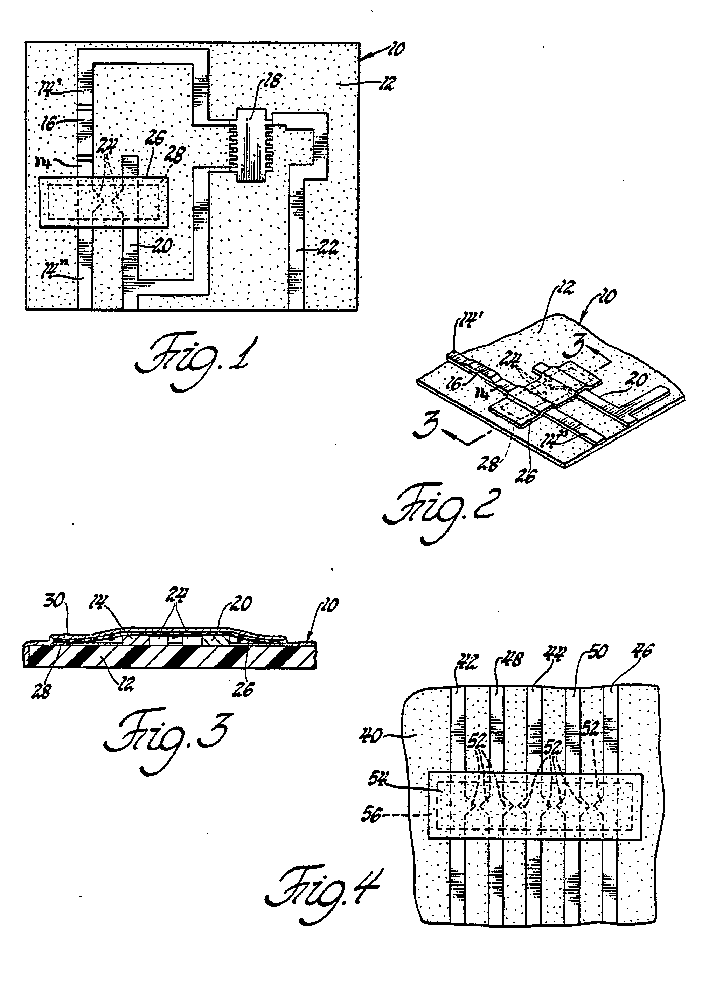

As shown in Figures 1, 2 and 3, a printed circuit board 10 comprises a substrate 12 of dielectric material having a first conductor 14 having portions 14' and 14" which are spaced to accommodate a resistor 16 which is soldered to the ends of the portions and acts as a current limiting resistor. The first conductor 14 forms the signal input to a semiconductor circuit package 18 which may, for example, be a CMOS (complimentary metal-oxide semiconductor)device or other load. A second conductor 20 has a branch extending parallel to the first conductor 14 and a branch extending to the semiconductor circuit package 18 and serves as a ground conductor. A third conductor 22 is coupled to the semiconductor circuit package 18 to supply power thereto. The first and second conductors 14 and 20 each have at one side a discharge point or electrode 24 projecting toward the other discharge point to define a spark gap. In the interest of achieving a dielectric breakdown at a low voltage the spark gap is made as small as possible consistent with the practical manufacture of printed circuit boards. In practice, a spacing of 0.381 mm (0.015 inches) between the discharge points 24 was found to be practical since it is easily fabricated and discharges occurred in air at voltage levels not exceeding 200 volts. Discharge point 24 radii of 0.0635 to 0.1905 mm (0.0025 to 0.0075 inches) were tried and only minor variations in discharge voltage were observed.

To maintain a controlled atmosphere at the spark gap and to exclude conformal coating material from the spark gap a tape 26 is secured to the printed circuit board 10 over the region of the discharge points 24, the tape holding a minute bubble of air or a trace of air in the spark gap. The tape 26 may be covered with adhesive on one side so long as the adhesive does not intrude into the spark gap. Even if the tape 26 adheres to the top of the discharge points 24 an air gap is maintained if the first and second conductors 14,20 are sufficiently raised above the surface of the substrate 12. Preferably, however, the tape 26 contains a coating of adhesive 28 around its perimeter or border which secures the tape to the printed circuit board 10 to define a protected region between the tape and the substrate 12. A conformal coating 30, as shown in Figure 3, is applied over one or both surfaces of the printed circuit board 10 to protect the circuitry from moisture or other contaminants which might affect its operation. A number of suitable materials for the conformal coating 30 are commercially available, e.g. Dow Corning QI 2620. The conformal coating 30 increases the dielectric constant between adjacent conductors 14,20,22 and thus is very important, especially for very close conductor spacings. In addition the conformal coating 30 improves the isolation of the portions 14' and 14" of the first conductor 14 to prevent arcing around the resistor 16. Thus any discharge is effectively steered to the spark gap between the discharge points 24. The conformal coating 30 also hermetically seals the tape 26 so that any air beneath the tape is permanently contained. In the manufacture of the printed circuit board 10, the printed circuit board is heated in a dry atmosphere to drive out moisture before the tape 26 is applied. The dry atmosphere is preferably air but other gases may be used if desired. The conformal coating 30, of course, is applied after the tape 26 is secured to the substrate 12.

Figure 4 illustrates a second embodiment of the invention incorporating many spark gaps on a single printed circuit board and covered with a single piece of tape. In this case, a printed circuit board 40 has three separate conductors 42, 44 and 46 for signal carrying arranged parallel to one another and separated by a pair of grounded conductors 48 and 50. Each of the conductors 42-50 has one or two discharge points 52 directed toward neighbouring conductors to define small spark gaps therebetween as in Figure 1. A single tape 54 with an adhesive border 56 must span the entire array of spark gaps to form an air space around the spark gaps. This arrangement allows a number of circuits on the same printed circuit board to be provided with high voltage transient protection. Preferably a conformal coating is applied to this device as described previously.

Conveniently the tape 26 or 54 serves a second function that of carrying an identifying code or number such as a date or serial number as may be necessary. The conformal coating must be sufficiently translucent to permit legibility of the identification. Thus the tape 26,54, which is an inexpensive component of the printed circuit board 10,40, can serve two necessary functions.

It will thus be seen that according to this invention an inexpensive arrangement is provided for limiting high voltage transients to a few hundred volts thereby preventing damage to the components on a printed circuit board, the high voltage transient protection device being operative for repetitive high voltage transient inputs, and also capable of overcoming the other disadvantages associated with the previously known arrangements.

## Claims

1. A high voltage transient protection device for a printed circuit board (10,40) comprising a substrate (12) of dielectric material, and at least a pair of closely spaced conductors (14,20,42-50) on the substrate defining a spark gap for discharging high voltage, the high voltage transient protection device being characterised by a tape (26,54) secured to the printed circuit board (10,40) and overlying the spark gap to trap gas in the spark gap.

2. A high voltage transient protection device as claimed in claim 1 characterised in that the tape (26,54) is formed with a coating of adhesive (28,56) around its border for securing the tape to the printed circuit board (10,40) with the centre of the tape spaced from the substrate (12) in the region of the spark gap.

3. A high voltage transient protection device as claimed in claim 1 or claim 2, characterised in that the conductors (14,20,42-50) are coupled to a load (18) to be protected; in that a resistor (16) is positioned in a path of one of the conductors for limiting current to the load; and in that a conformal coating (30) covers the printed circuit board including the resistor and the tape (26,54), whereby the conformal coating prevents discharge across the resistor, and the tape excludes the material of the conformal coating from the spark gap.

4. A high voltage transient protection device as claimed in claim 3, characterised in that several conductors (42-50) form spark gaps between adjacent pairs of conductors, the spark gaps being closely grouped, and the tape (54) covering all the spark gaps.

## Patentansprüche

1. Überspannungs-Schutzvorrichtung für eine gedruckte Schaltplatine (10, 40) mit einem Substrat (12) aus dielektrischem Material und mindestens zwei Leitern (14, 20, 42–50) mit engem Abstand an dem Substrat, die einen Funkenspalt zur Hochspannungsentladung bestimmen, wobei die Überspannungs-Schutzvorrichtung gekennzeichnet ist durch ein an der gedruckten Schaltplatine (10, 40) befestigtes und den Funkenspalt zum Einschließen von Gas in dem Funkenspalt überdeckendes Band (26, 54).

2. Überspannungs-Schutzvorrichtung nach Anspruch 1, dadurch gekennzeichnet, daß das Band (26, 54) mit einer Klebebeschichtung (28, 25) um seine Kante ausgebildet ist, um das Band an der gedruckten Schaltplatine (10, 40) so zu befestigen, daß die Mitte des Bandes in dem Bereich des Funkenspaltes von dem Substrat (12) einen Abstand besitzt.

3. Überspannungs-Schutzvorrichtung nach Anspruch 1 oder 2, dadurch gekennzeichnet, daß die Leiter (14, 20, 42–50) mit einer zu schützenden Last (18) gekoppelt sind und daß ein Widerstand (16) in den Weg eines der Leiter eingesetzt ist, um den Laststrom zu begrenzen, und daß eine konforme Beschichtung (30) die Schaltplatine einschließlich Widerstand und Band (26, 54) bedeckt, wodurch die konforme Beschichtung eine Entladung über den Widerstand verhindert und das Band das Material der konformen Beschichtung von dem Funkenspalt ausschließt.

4. Überspannungs-Schutzvorrichtung nach Anspruch 3, dadurch gekennzeichnet, daß mehrere Leiter (42–50) Funkenspalte zwischen benachbarten Leiterpaaren bilden, wobei die Funkenspalte eng gruppiert sind und das Band (54) alle Funkenspalte bedeckt.

## Revendications

1. Dispositif de protection contre les surtensions pour une carte à circuits imprimés (10, 40) comprenant un substrat (12) d'un matériau diélectrique, et au moins une paire de conducteurs contigus (14, 20, 42 à 50) sur le substrat définissant un éclateur pour décharger la haute tension, le dispositif de protection contre les surtensions étant caractérisé par un ruban (26, 54) fixé à la carte à circuits imprimés (10, 40) et recouvrant l'éclateur pour enfermer le gaz dans l'éclateur.

2. Dispositif de protection contre les surtensions selon la revendication 1, caractérisé en ce que le ruban (26, 54) est formé avec un revêtement d'adhésif (28, 56) autour de son bord pour fixer le ruban à la carte à circuits imprimés (10, 40) avec le centre du ruban écarté du substrat (12) dans la région de l'éclateur.

3. Dispositif de protection contre les surtensions selon la revendication 1 ou 2, caractérisé en ce que les conducteurs (14, 20, 42 à 50) sont connectés à une charge (18) devant être protégée; en ce qu'une résistance (16) est placée dans un trajet d'un des conducteurs pour limiter le courant vers la charge; et en ce qu'un revêtement adapté (30) recouvre la carte à circuits imprimés comprenant la résistance et le ruban (26, 54), par quoi le revêtement adapté empêche la décharge aux bornes de la résistance, et le ruban exclut le matériau du revêtement adapté de l'éclateur.

4. Dispositif de protection contre les surtensions selon la revendication 3, caractérisé en ce que plusieurs conducteurs (42 à 50) forment des éclateurs entre des paires adjacentes de conducteurs, les éclateurs étant groupés étroitement, et le ruban (54) recouvrant la totalité des éclateurs.

Fig. 1

Fig. 2

Fig. 3

Fig. 4